(19)

Europäisches Patentamt

European Patent Office

Office européen des brevets

(11) **EP 3 206 052 A1**

(12) **EUROPEAN PATENT APPLICATION**

(43) Date of publication:
16.08.2017 Bulletin 2017/33

(51) Int Cl.:
*G01V 1/38* (2006.01)    *G01V 1/00* (2006.01)

(21) Application number: 17305155.8

(22) Date of filing: 10.02.2017

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
MA MD

(30) Priority: 12.02.2016  US 201662294344 P
10.03.2016  US 201662306178 P

(71) Applicant: CGG Services SAS
91300 Massy (FR)

(72) Inventors:
• ELBOTH, Thomas
91300 MASSY (FR)

• SANCHIS, Charlotte
91300 MASSY (FR)
• SVAY, Julie
91300 MASSY (FR)
• MOULINIER, Timothée
91300 MASSY (FR)
• SILIQI, Risto
91300 MASSY (FR)

(74) Representative: Petit, Maxime
Ipsilon
Le Centralis
63, avenue du Général Leclerc
92340 Bourg-la-Reine (FR)

(54) **SEISMIC DATA ACQUISITION FOR COMPRESSIVE SENSING RECONSTRUCTION**

(57) A survey plan is designed and potentially adjusted so that seismic data acquired during the survey include inline and cross-line seismic data irregularities suitable for compressive sensing reconstruction. At least one of the inline and cross-line irregularities is dynamic and may be due to source, vessel(s) and/or streamer steering.

FIG. 9

900

Start

Determining shot positions and corresponding detector positions of a survey plan with inline and cross-line irregularities caused by at least one data acquisition geometry-varying action — 910

Evaluating a cost function value for the determined shot and detector positions — 920

Determining, using the cost function value, whether seismic data acquired according to the survey plan is suitable compressive sensing reconstruction — 930

Stop

EP 3 206 052 A1

Description

## CROSS-REFERENCE TO RELATED APPLICATIONS

The present application is related to and claims the benefit of priority of U.S. Provisional Application 62/294,344 filed February 12, 2016, and U.S. Provisional Application 62/306,178 filed March 10, 2016, the entire contents of which are incorporated herein by reference.

## BACKGROUND

## TECHNICAL FIELD

Embodiments of the subject matter disclosed herein generally relate to methods and systems for subsurface exploration, and, in particular, to methods and systems for marine seismic data acquisition and processing that enable efficient interpolation and regularization in compressive sensing to either improve image quality or reduce acquisition time while achieving the same image quality.

## DISCUSSION OF THE BACKGROUND

Probing underground formations in search of hydrocarbon resources is an ongoing process driven by continually increasing worldwide demand. Seismic surveys are used for exploration, hydrocarbon reservoir field development, and production monitoring (time lapse).

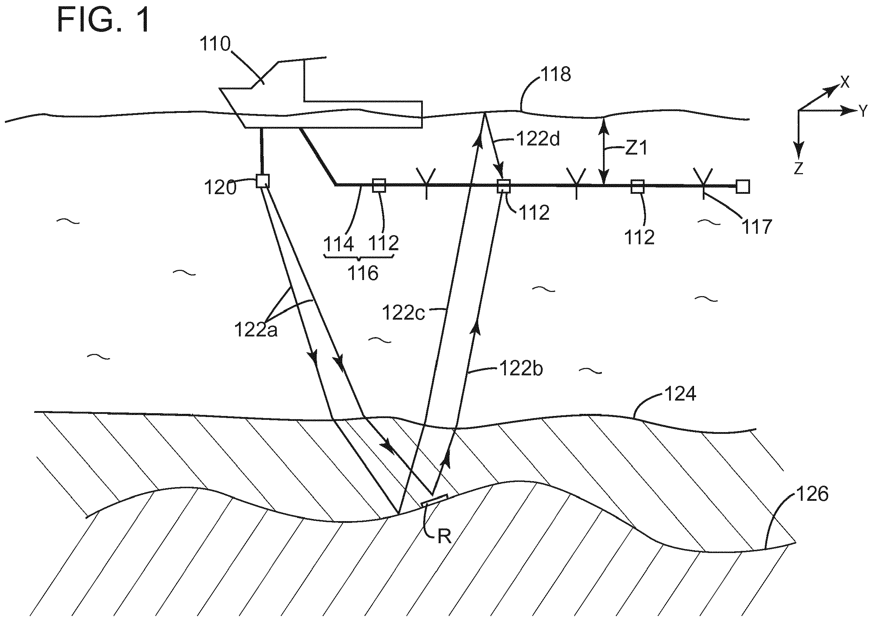

Figure 1, illustrates equipment used during a marine seismic survey. A vessel 110 tows plural detectors (also called "seismic sensors") 112, which are disposed along a flexible cable 114 (typically several kilometers long). Those skilled in the art use the term "streamer" (labeled 116) for the cable and the corresponding detectors. A vessel usually tows plural streamers at predetermined cross-line intervals (cross-line being a direction perpendicular to the towing direction), with the streamers forming a spread in the horizontal (xy) plane. Streamer 116 is towed at a substantially constant depth $z_1$ relative to the water surface 118. However, streamers may be towed at a slant (i.e., to form a constant angle) with respect to the water surface, or may have a curved profile as described, for example, in U.S. Patent No. 8,593,904, the entire content of which is incorporated herein by reference. Each streamer is normally equipped with compasses, acoustic pingers and depth sensors that give continuous location information about heading, position and depth. Furthermore, each streamer is typically equipped with attached units 117 (only one labeled) known as "birds" that control cross-line position and depth of that streamer (control operations often referred to as streamer steering).

Vessel 110 (or another vessel) may also tow seismic source 120 configured to generate acoustic waves 122a. Note that, in this document, the terms "acoustic" and "seismic" are interchangeably used to indicate the same type of mechanical energy propagation (i.e., waves). Acoustic waves 122a propagate downward and penetrate the seafloor 124. For simplicity, Figure 1 shows only two paths 122a corresponding to the source-emitted acoustic waves. When encountering a layer interface 126 (the wave propagating with different velocities inside different layers), the acoustic waves are at least partially reflected. Reflected acoustic waves 122b and 122c propagate upward. Reflected acoustic wave 122b is received by one of detectors 112, while reflected wave 122c passes by the detectors and is reflected back at the water surface 118 (the interface between the water and air serving as a quasi-perfect reflector to mirror acoustic waves). Wave 122d, which is wave 122c's reflection due to the water surface, travels downward and is then also detected.

A seismic source 120 is typically made up of a number of individual source elements that each emits acoustic energy (i.e., seismic waves). The individual source elements may be air guns, sparkers, vibrators, etc., or a combination of these types of source elements. Subsets of the source elements are normally attached one after another to the same towing cable to form source strings (also known as source subarrays, the seismic source being then called source array). A typical marine seismic source includes two or more source strings. The combination of different source strings that are simultaneously activated defines the center of the seismic source. By combining the source strings differently, the center of the seismic source is virtually changed. The source strings and/or the entire source may be configured to be steered cross-line. Some examples of steerable sources are described in U.S. Patents 8,462,581; 8,891,331; and 8,889,332, the entire contents of which are incorporated herein by reference.

Thus, each time a seismic source is activated, it emits a seismic signal that travels downward through the explored underground formation, is reflected, and, upon its return, is received by the detectors along the streamer(s). The detected signals related to multiple seismic source and seismic sensor position combinations are recorded as seismic data, which is then processed to generate a profile (structural image) of the underground formation.

Data acquisition geometry is determined by the equipment employed and by the manner the equipment is operated. The basic arrangement in Figure 1 illustrates a vessel towing a streamer housing multiple seismic receivers, and a seismic source. In another marine seismic acquisition layout, the vessel towing the seismic source (called the source vessel) is different from the vessel towing one or more streamers (called the streamer vessel). The source vessel may be located next to the streamer vessel, such as in wide azimuth (WAZ) data acquisition systems, on top of the seismic spread or behind the tail end of the seismic spread. The source vessel may navigate on a sail line substantially parallel to the streamer vessel's sail line, or it may navigate on a sail line which makes a non-zero azimuth angle (in horizontal plane) with the streamer vessel's sail line, or yet it may have a varying trajectory, such as zig-zag or circular. Another marine seismic acquisition system may include one or more streamer vessels and/or one or more source vessels.

A seismic trace is a term associated with acoustic energy that is detected by one or more seismic sensors (i.e., detectors). Typically, a trace is determined by combining a group of seismic sensors over a certain length, sometimes referred to as a "receiver length" or "group length." A group of seismic sensors may also be referred to as a "receiver." In marine seismic, this group length is typically between 3.125 to 12.5 m but, in some examples, a seismic trace can also be a recording of a received seismic signal from one single seismic sensor. In other words, a "seismic sensor" refers to a single seismic sensor or a group of seismic sensors.

A location on a horizontal plane, which is halfway between the center of the seismic source and the center of the seismic sensor, is referred to as a common mid-point (CMP). Plural pairs of seismic source centers and seismic sensors may have the same CMP. The CMP of every trace in a seismic survey is carefully tracked (e.g., it may be included in the trace header information) to allow the information contained within the traces to be correlated with specific underground locations. The locations of seismic sources when seismic waves are generated, and of seismic sensors detecting reflections of the seismic waves, respectively, are used for a variety of acquisition and/or processing purposes.

During processing, the area (known as the "survey area") in a horizontal plane explored during a seismic survey is customarily divided into a regular grid of small, adjacent cells (called "bins") characterized by widths $\Delta x$ (along the towing direction) and $\Delta y$ (perpendicular to the towing direction). Each CMP pertains to a bin and it is associated with the bin's midpoint. Presence of at least measurement (CMP-trace) inside each bin of the survey area simplifies processing and ensures uniform survey area coverage (with no big holes in the acquisition). The bin size is typically in the range of 3.125 to 50.0 m both inline and cross-line.

Bin sizes are determined by the imaging objective: the smaller the bins, the better the resolution, revealing smaller structural features of the underground formation. However, high resolution also requires that sufficient reflected acoustic energy be received from the locations of interest ("targets"). This last requirement may be difficult to fulfill for deep targets or for targets beneath complex geological features.

During the planning stage of a seismic survey, so-called pre-plots are generated. The pre-plots represent the intended positions of sources and receivers for each shot (i.e., source activation) during a survey. The pre-plots are used to design a plan for source and streamer trajectories and a source activation schedule so that each bin will be well-sampled.

Time-lapse 4D geophysical imagining combines at least two surveys acquired for the same area to determine changes that have occurred inside the underground formation in the time interval between the surveys (which may be a few months or years). It is desirable that the two or more surveys reproduce both source and receiver positions as closely as possible. The post-plots of a first survey (known as the "base") may be used as pre-plots for planning the later survey(s) (known as "monitor(s)").

Image resolution with traditional processing and acquisition techniques is limited according to the Shannon-Nyquist sampling theorem. In view of this limitation, sample density and the number of samples per bin are determined to successfully image the underground formation. Compressed sensing (also known as compressive sensing, compressive sampling, sparse inversion or sparse sampling) is a more recently developed signal-processing technique for efficiently acquiring and/or reconstructing a sparsely sampled signal, by finding solutions to underdetermined linear systems. This signal processing technique exploits the sparsity of the signal samples to optimally recover information about the underground formation's structure from far fewer samples than those required according to the Shannon-Nyquist sampling theorem. Two conditions have to be met to make this recovery possible.

The first condition is sparsity, which requires that a sparse representation of the signal be present. Any transform domain in which the signal is decomposed in an orthonormal basis so that the signal is represented by only a few non-zero coefficients is applicable. Such a transformation may be, for example, the Fourier transform, the wavelet transform, the curvelet transform, the f-k transform or the Gabor transform.

The second condition is incoherence in the sparsifying domain. Irregular sampling in the acquisition domain breaks under-sampling artifacts by turning them into harmless noise. The signal of interest is then reconstructed by using sparsity-promoting inversion methods such as, for instance, the spectral projected gradient for L1 norm (SPGL1 ).

To break the coherence and make marine seismic data more favorable to compressed sensing reconstruction, it has been suggested (see, e.g., U.S. Patent No. 8,897,094 the entire content of which is incorporated herein by reference) to vary cross-line intervals between parallel streamers and/or towing the streamers in such a way that a cross-line distance there-between increases along the streamer's lengths. Such cross-line distance variations create static irregularities in the cross-line direction but do not generate inline irregularities.

Li et al.'s article, "Marine towed streamer data reconstruction based on compressive sensing," published in SEG Technical Program Expanded Abstracts 2013, pp. 3597-3602, and Mosher et al.'s article, "Increasing the efficiency of seismic data acquisition via compressive sensing," published in The leading edge, v. 33 no. 4, pp. 386-391, suggest using irregular shot spacing to create inline irregularities. U.S. Patent 9,188,693 also describes a method for acquiring marine seismic data according to which the seismic source is actuated such that distances between actuation positions vary randomly, thereby creating inline irregularities.

U.S. Patent No. 8,780,669 proposes improving seismic data azimuth coverage by steering the vessel in a sinusoidal pattern. Such source steering yields irregularities both inline and cross-line. However, a vessel is only able to slowly vary its course. The shot-to-shot irregularities are therefore small, and the resulting irregularities are not optimal for compressed sensing reconstruction.

U.S. Patent Nos. 8,681,581 and 8,711,654 describe randomizing the distribution of receivers and sources during a coil shoot acquisition by varying the turn radius and coil circle centers of vessel(s). Although this is an effective approach in a deep-water environment, for more shallow targets, the shot-to-shot irregularities would be small, since a vessel turns slowly compared to the typical bin size. Additionally, such methods are not relevant for conventionally acquired data, along relatively straight lines.

U.S. Patent Application Publication No. 2011/0317517 describes a data acquisition system allowing individual seismic sensors of a streamer be turned on or off. However, such on-off toggling of the receivers apparently yields static inline irregularities and actually artificially forfeits information.

Thus, there is a need to propose methods that better ensure irregularities in data acquisition, rendering the data more favorable to compressive sensing or sparse inversion-based reconstruction and regularization.

## SUMMARY

Methods and devices according to various embodiments design and/or enhance inline and cross-line seismic data irregularities so that acquired seismic data to be suitable for compressive sensing reconstruction. The irregularities may be obtained dynamically using source, vessel(s) and/or streamer steering.

According to an embodiment, there is a method for designing a survey plan that achieves inline and cross-line seismic data irregularities suitable for compressive sensing reconstruction. The method includes determining shot positions and corresponding detector positions of a survey plan with inline and cross-line irregularities caused by at least one data acquisition geometry-varying action. The method further includes evaluating a cost function value for the determined shot and detector positions, and determining, using the cost function value, whether seismic data acquired according to the survey plan is suitable compressive sensing reconstruction.

According to an embodiment, there is a survey control method for monitoring and adjusting data acquisition geometry to achieve inline and cross-line seismic data irregularities suitable for compressive sensing reconstruction. The method repeatedly performs evaluating a cost function for shot positions and corresponding detector positions acquired to include inline and cross-line irregularities caused by at least one data acquisition geometry-varying action. A corrective action is sought if the evaluated cost differs from a planned cost by more than a predetermined threshold value. The corrective action has to cause irregularities that alter the shot positions and corresponding detector positions such as to bring an updated cost value based on altered shot and detector positions within the predetermined threshold value from the planned cost.

According to yet another embodiment, there is a data acquisition control apparatus configured to design and/or adjust source, vessel and/or streamer trajectories during a survey to achieve inline and cross-line seismic data irregularities optimized for compressive sensing reconstruction. The apparatus includes an interface configured to receive data acquisition related information and to output a survey plan and/or a correction thereof, and a data processing unit connected to the interface. The data processing unit is configured to evaluate a cost function value for a set of shot and detector positions with inline in cross-line irregularities caused by at least one data acquisition geometry-varying action, and to determine, using the cost function value, whether seismic data acquired according to the set of shot and detector positions is suitable compressive sensing reconstruction.

## BRIEF DESCRIPTION OF THE DRAWINGS

The accompanying drawings, which are incorporated in and constitute a part of the specification, illustrate one or more embodiments and, together with the description, explain these embodiments. In the drawings:

Figure 1 is a schematic diagram of a marine seismic data acquisition system;

Figure 2 illustrates a 2-dimensional hypercube with three boxes and six points therein, for explaining the definition of discrepancy;

Figures 3A and 3B are graphs illustrating sampling positions and corresponding kx-ky plots for a conventional linear sampling over a rectangular CMP bin grid;

Figures 4A and 4B are graphs illustrating sampling positions and corresponding kx-ky plots for a snaky sampling over a rectangular grid;

Figures 5A and 5B are graphs illustrating sampling positions and corresponding kx-ky plots for a random sampling over a rectangular grid;

Figures 6A-D are graphs related to data acquired with a regular sampling;

Figures 7A-D are graphs related to data acquired using a Hammersley sequence;

Figures 8A-D are graphs related to data acquired with a uniform random sampling;

Figure 9 is a flowchart of a survey planning method according to an embodiment;

Figure 10 is a cross-line view of one source and two receivers;

Figure 11 is a flowchart of a survey control method according to an embodiment;

Figures 12A and 12B are graphs related to data acquired with irregular streamer cross-line intervals;

Figures 13A and 13B are graphs related to data acquired with multiple irregularity-inducing actions; and

Figure 14 is a schematic diagram of a data acquisition control apparatus according to an embodiment.

## DETAILED DESCRIPTION

The following description of the exemplary embodiments refers to the accompanying drawings. The same reference numbers in different drawings identify the same or similar elements. The following detailed description does not limit the invention. Instead, the scope of the invention is defined by the appended claims. The following embodiments are discussed, for simplicity, with regard to the terminology of marine seismic surveys. However, the inventive concepts to be discussed next are not limited to marine seismic surveys, but may also be applied for land surveys and surveys with electromagnetic waves.

Reference throughout the specification to "one embodiment" or "an embodiment" means that a particular feature, structure or characteristic described in connection with an embodiment is included in at least one embodiment of the subject matter disclosed. Thus, the appearance of the phrases "in one embodiment" or "in an embodiment" in various places throughout the specification is not necessarily referring to the same embodiment. Further, the particular features, structures or characteristics may be combined in any suitable manner in one or more embodiments.

Recently developed signal processing methods (referred to as "compressive sensing") enable under certain conditions (as discussed in the Background section) more accurate recovery of a sparsely sampled signal than the regularly sampled data. The embodiments described in this section are related to acquiring/sampling marine seismic data irregularly for compressive sensing reconstruction (i.e., to optimally recover the structural information related to the probed substructure, which information is embedded in the signals). These embodiments simultaneously achieve both inline and cross-line irregularities, at least one of which is dynamic. The vessel, source and/or streamer steering are used optimize cross-line and inline irregularities for compressive sensing reconstruction, enabling improved quality and/or improved efficiency. For example, the quality of seismic imaging may be improved for the same source-receiver sampling density as conventionally acquired, or the image quality may be maintained in spite of reduced source-receiver sampling density (and, thus, reduced acquisition time). The techniques are described for towed streamers and sources but may also be applied for seismic acquisition with autonomous underwater vehicles (AUVs) and for ocean bottom nodes or cable (OBN/OBC) seismic acquisition, with any type of source and receiver.

In order to successfully recover a signal through compressive sensing methodology, the signal needs to be sparse (at least in some suitable transform domain), and the sub-sampling artifacts must be incoherent in the sparse domain. The seismic data acquisition for compressive sensing aims to create Gaussian noise-like sub-sampling artifacts, which can be effectively attenuated by a sparse recovery algorithm that separates the noise from the desired signal.

Mathematically, if acquired data is the *n x 1* vector *y* and the interpolation grid is the *N x 1* vector *f* where *n<<N,* then the restriction equation is:

$$y = Rf \qquad (1)$$

where *R* is a *n x N* restriction matrix. The acquired data does not necessarily fit into the interpolation grid and, therefore, the restriction matrix may include interpolation coefficients derived from a *p*-order interpolation of acquired data fitting into the interpolation grid, *p* being an integer greater or equal to 1.

If *S* is the *N x N* orthogonal sparsifying matrix and the *N x 1* vector *x* is the sparse representation of the interpolation grid, then the sparse transform is:

$$x = Sf. \qquad (2)$$

Combining the sparse transform and restriction equation leads to:

$$y = RS^H x = Ax, \qquad (3)$$

where $A = RS^H$ is the dictionary matrix.

Compressive sensing reconstruction consists of the sparse inversion of equation (3), i.e., minimizing the norm of $x$ subject to $\|y - Ax\|_2 \leq \sigma$ where $\sigma$ represents the noise variance.

One way of assessing incoherence/irregularity is to analyze a kx-ky spectrum (two-dimensional, 2D, spatial Fast Fourier Transform, FFT) of the sample points in a 2D spatial grid. In a seismic data acquisition, the sample points are typically the CMP positions within a given offset range. Examples of 2D grids are inline-cross-line, offset-inline, offset-cross-line or any other combinations familiar to anyone skilled in the art of seismic data processing. If the spatial sampling were uniformly random, no coherent events would be present in this spectrum, and a zero-centered Gaussian noise would spread over the entire frequency spectrum. The more regular sample points yield coherent events in the kx-ky spectrum that are observed as vertical or horizontal stripes.

The suitability of a proposed sampling/acquisition plan may be assessed using a cost function that evaluates incoherence, for example, in the kx-ky domain. The cost function may be, for example, mutual coherence, entropy or discrepancy. The mutual coherence of matrix A is defined as the maximum absolute value of the cross-correlations between the columns of the matrix. The entropy of matrix A measures the amount of "disorder" by summing a probability mass function. These cost functions however do not ensure that no large gaps occur between sample (acquisition) points. Discrepancy is a measure of deviation from uniformity of a sequence of points in the half-open interval $D = [0,1)$. Consider the s-dimensional half-open unit cube $I^s = [0,1)^s$, $s \geq 1$. For N points $x_1, x_2, \ldots, x_N \in I^s$ in this space and for any sub-interval $J \in I^s$, if $A(J)$ is the number of points $x_i$ in J and $V(J)$ is the volume of $J$, then discrepancy $D(J,N)$ is defined as

$$D(J, N) = \left| \frac{A(J)}{N} - \frac{V(J)}{V_{tot}} \right|, \qquad (4)$$

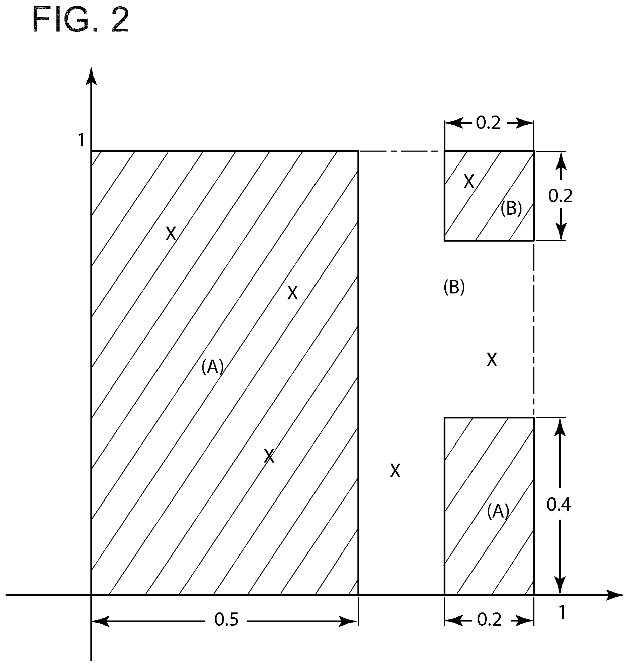

According to one definition, the discrepancy is the difference between the proportion of points in J compared to the full unit cube $I^s$ and the volume of the "box" $J$ compared to $I^s$. Figure 2 shows a 2-dimensional hypercube $I^s = [0,1)^2$ (a square) with six points. Three sub-intervals (or boxes) A, B and C are shaded. The discrepancy of box A, which contains 3 points, is calculated according to equation (4) as:

$$D(1,6) = \left| \frac{3}{6} - \frac{1}{2} \right| = 0. \qquad (5)$$

Similarly, the discrepancy of boxes B and C are $\approx 0.1267$ and $0.8$ respectively. The above presented formula is the conventional definition of discrepancy. However, in a more practical setting we can also define discrepancy as:

$$D(J, N) = \left| \frac{N}{V_{tot}} - \frac{A(J)}{V(J)} \right|. \qquad (6)$$

With this definition, a value $D = 0$ for all sub-intervals $J$ outlines a perfectly uniform distribution of points.

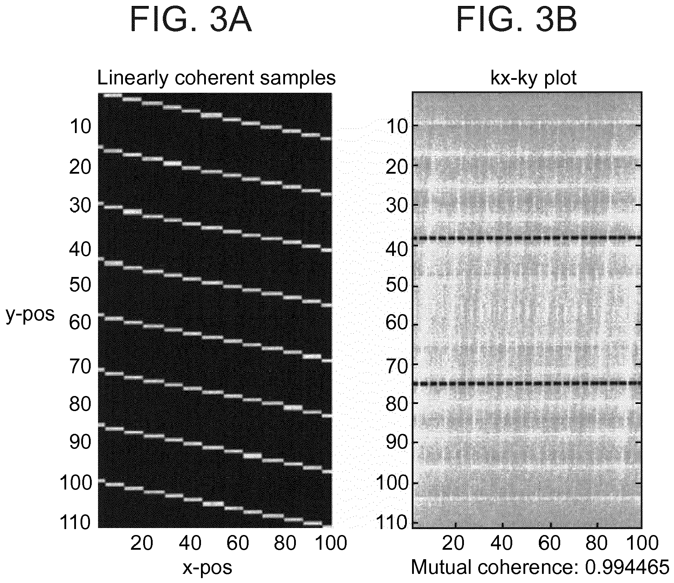

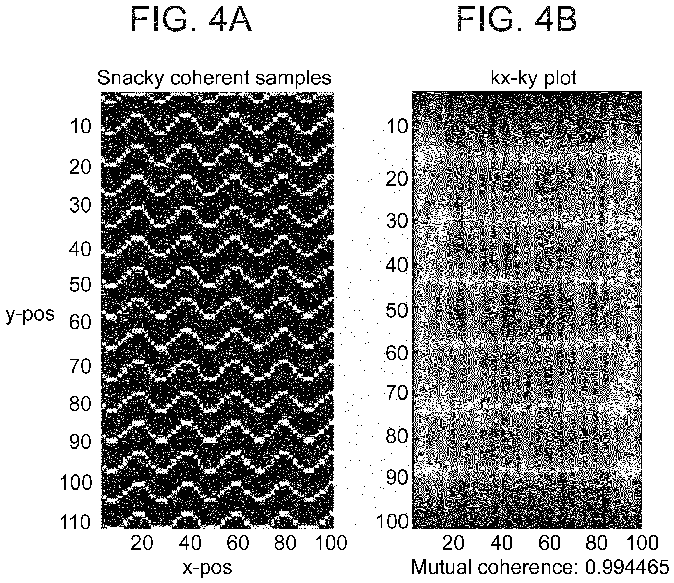

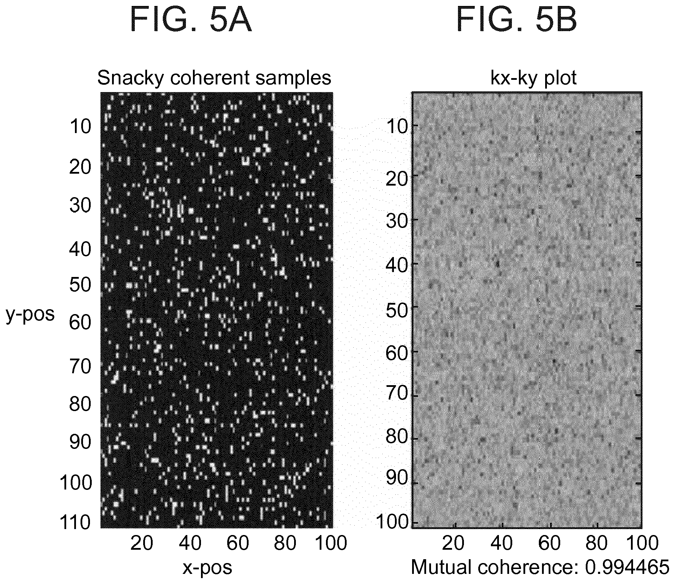

To illustrate the difference between conventional sampling and irregular sampling, consider the pairs of graphs 3A-3B, 4A-4B and 5A-5B. Figures 3A, 4A and 5A are 2-dimensional plots illustrating x and y sampling positions, and Figures 3B, 4B and 5B are kx-ky plots corresponding to the sampling positions illustrated in Figures 3A, 4A and 5A, respectively. Figures 3A and 3B represent a conventional linear sampling over a rectangular CMP bin grid, Figures 4A and 4B represent a snaky sampling (i.e., the sampling points follow periodically waving curves) over a rectangular grid, and Figures 5A and 5B represent a random sampling over a rectangular grid. Figure 3B reveals a strong coherent correlation, the mutual coherence being a high number. Figure 4B shows less coherence than Figure 2B, but the mutual coherence is still very high. Figure 5B reveals far less coherence, and the corresponding mutual coherence is significantly decreased.

In another example, the cost function is computed on the dictionary matrix A. Minimizing the cost function between the restriction matrix R and the sparse matrix $S$, makes $x$ as sparse as possible (see, e.g., the article by Candès et al., published in Communications on Pure and Applied Mathematics 59 (8), pp. 1207-1223, the content of which is incorporated herein by reference).

In yet another example, the sub-sampling artifacts can be evaluated through a convolution matrix that characterizes the off-diagonal elements of the Gram matrix $A^H A$ (see, e.g., Hennenfent et al.'s 2008 article, "Simply denoise: wavefield reconstruction via jittered undersampling," published in Geophysics, 73, no. 3, pp. V19-V28, the content of which is incorporated herein by reference):

$$L = A^H A - \alpha I, \qquad (7)$$

where $\alpha$ is defined such that diag($L$) = 0. Thereby, the sub-sampling artifacts in the sparse domain for a given interpolation grid $f_0$ are then defined as:

$$z \equiv Lx_0, \qquad (8)$$

where $x_0 = Sf_0$. In this case, the cost function is applied to $z$ to ensure as few coherent events as possible.

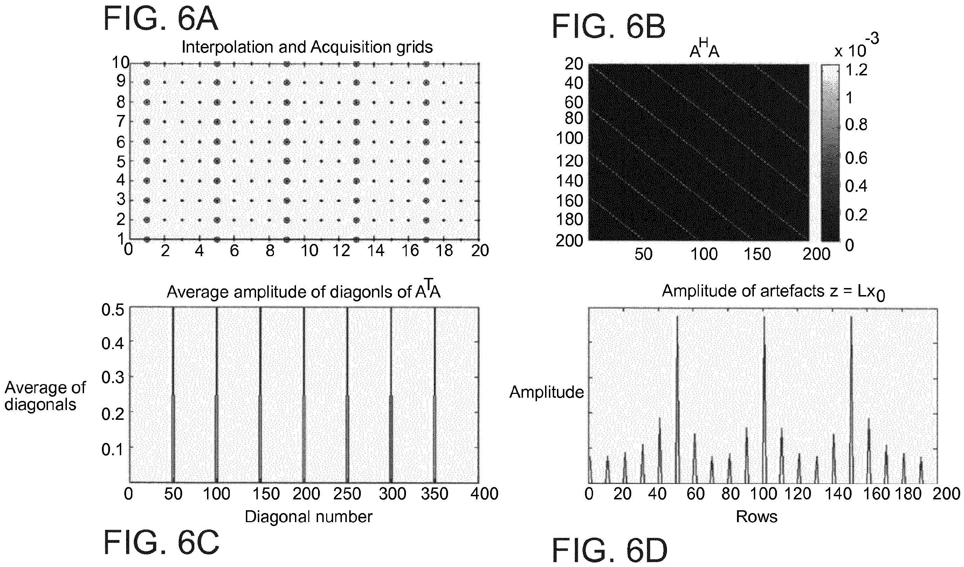

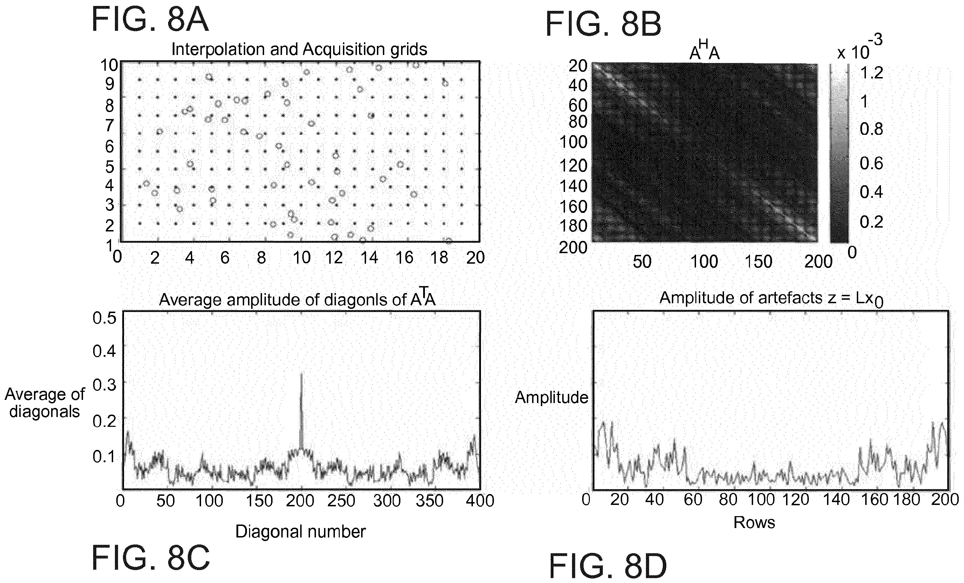

Figures 6A-D, 7A-D and 8A-D represent data acquired with regular sampling, using a Hammersley sequence (i.e., a low discrepancy from regular sampling) and uniformly (over the survey area) random (locally) sampled, respectively. Figures 6A, 7A and 8A are 2D x-y representations of the sampling points, Figures 6B, 7B and 8B are the 2D representations of the Gram matrices, Figures 6C, 7C and 8C are signal spectra, and Figures 6D, 7D and 8D are the sub-sampling artifacts' spectra.

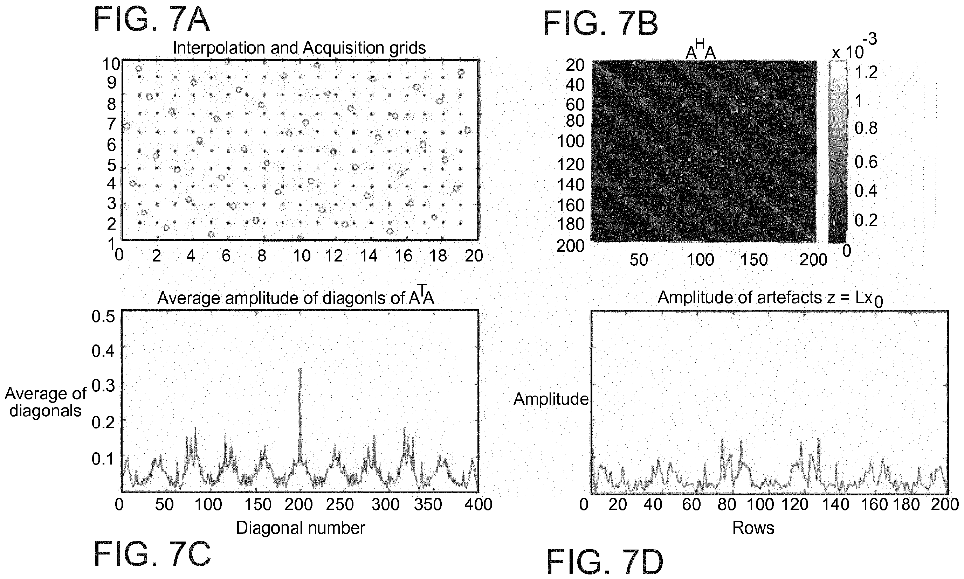

A comparison of Figures 6C and 6D shows that for regular sampling the artifacts are clearly coherent and cannot be distinguished from signal, this regular sampling data acquisition not being favorable to compressive sensing reconstruction. Additionally, large gaps in acquisition in Figure 6A focus the noise in Figure 6D, making its level larger. Comparisons between Figures 7C versus 7D and 8C versus 8D show that sub-sampling artifacts exhibit a noise-like spectra, which can be distinguished from the signal, thus favoring compressive sensing signal reconstruction.

The cost function may be used to design a survey plan or may be evaluated during the survey based on the actual acquired data. Ultimately, the cost function may be built based on the underground structure's image quality (e.g., data quality after migration). Such an approach may seem costly, but it is achievable using ever-increasing computing power. For example, the bandwidth of the recovered data may be evaluated, or the frequency at which spatial aliasing starts to appear may be determined. The image quality may be assessed based on the fk-plots of regularized and interpolated gathers at various processing stages.

Table 1 below sets forth actions or data acquisition geometry features yielding cross-line and/or inline irregularities. Irregularities may also be achieved in the z-direction (i.e., depth), by steering steamers up and down (i.e., dynamic irregularities) or by having various streamers and sources at varying depths (i.e., static irregularities). Such irregularities may be beneficial, especially for deghosting.

The actions or data acquisition geometry features in Table 1 may be used to achieve simultaneously inline and cross-line irregularities, that is, irregularities in an inline-cross-line seismic restriction matrix. The term "static" indicates irregularities that do not change data acquisition geometry during the survey, while the term "dynamic" refers to irregularities that change the data acquisition geometry during the survey. The "Other" column of Table 1 indicates actions or data acquisition geometry features that yield irregularities both inline and cross-line (as opposed to only inline or only cross-line in the other columns of Table 1). In other words, if each table item is a "dimension," these dimensions are not always orthogonal.

Table 1

| Inline irregularities | Cross-line irregularities | Other |
|---|---|---|
| STATIC: Irregular receiver spacing (most relevant for OBN/OBC) | STATIC: Irregular streamer spacing | STATIC/DYNAMIC: Streamer feathering and/or fanning |
| STATIC: Streamers towed to have their front ends at a different inline positions | STATIC: Irregular source strings spacing | DYNAMIC: Irregular source or steamer spacing caused by currents/environment/swell, etc. |

(continued)

| Inline irregularities | Cross-line irregularities | Other |
|---|---|---|
| DYNAMIC: Irregular streamer layback (i.e., actively and incoherently pulling individual streamers closer to the streamer vessel or releasing them farther from the streamer vessel using, e.g., winch mechanisms) | DYNAMIC: Actively steering the sources cross-line using source steering means (e.g., by using a motorized truck on a continuous spread rope as described in U.S. Patent Application based on 62/299,567, attorney docket number 0336-634/100992, which is incorporated herewith by reference) | STATIC/DYNAMIC : Varying layback or separation between vessels in multi-vessel acquisition |
| DYNAMIC: Irregular source layback (i.e., actively and incoherently pulling the source closer to the source vessel or releasing it farther from the source vessel using, e.g., winch mechanisms) | DYNAMIC: Actively steering the streamers from side to side with streamer steering | |
| DYNAMIC: Irregular shot point interval. (This is somewhat limited by the minimum gun cycle time) | DYNAMIC: Actively steering cross-line the streamer and/or source vessel | Positioning inaccuracies |
| | DYNAMIC: Activate only a (varying) subset of the available source strings | |

The irregularity-inducing data acquisition geometry features are limited by practical considerations. For example, the detectors are typically placed at regular intervals along the seismic streamers. The detector placement is not easily changed on existing conventional streamers, but it may be more easily achieved for OBN/OBC equipment. Further, seismic sources, especially air-gun sources, have a minimum cycle time depending on the source size, the number of source elements and compressor capacity, etc. This minimum cycle time may be 2-10 s, which together with efficiency concerns (i.e., one does not want to tow equipment without acquiring data) limits the shot point positions/time irregularities. Active steering (of a vessel, streamer or source) is limited by a maximum speed, phase, and maximum amplitude within the data acquisition geometry in order to functionally maintain the towing arrangement. For example, it is common practice to have a minimum cross-line distance, typically 20-50 m, in order to reduce the risk of streamer and/or source tangling. On the other hand, large separations of the source and receivers causes a decrease in the signal-to-noise ratio, with the level of the noise-like artifacts in the sparsifying domain becoming too large for the sparsity-promoting inversion methods to successfully estimate the signal. Referring to Table 1, there are at least 10 different "dimensions" where one can introduce irregularities in the seismic sampling. In addition, the environment causes irregularities through swells, currents, etc. With ~10 degrees of freedom (the number of dimensions), the search space for an optimal acquisition strategy is huge.

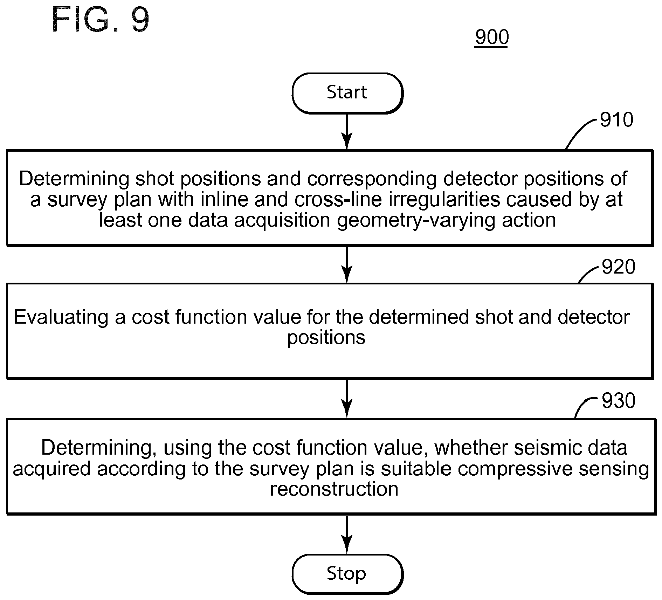

Figure 9 is a flowchart of a method 900 for designing a survey plan that achieves inline and cross-line seismic data irregularities suitable for compressive sensing reconstruction. Method 900 includes determining shot positions and corresponding detector positions of a survey plan with inline and cross-line irregularities caused by at least one data acquisition geometry-varying action at 910. In other words, the dynamic irregularities are planned whether or not static irregularities are also part of the plan. The term "geometry-varying" indicates that the relative positions of shots and receivers are changed. The word "action" indicates the dynamic nature of the change.

Further, method 900 includes evaluating a cost function value for the determined shot and detector positions at 920. Method 900 also includes determining, using the cost function value, whether seismic data acquired according to the survey plan is suitable compressive sensing reconstruction at 930.

The data acquisition geometry-varying action may be actively steering cross-line a source using source steering means, actively steering cross-line one or more streamers using streamer steering means, the one or more streamers carrying detectors, actively steering cross-line a source vessel, or shooting a source at irregular intervals. The data acquisition geometry-varying action may also be actively and incoherently modifying a distance between a source and a vessel towing the source, and/or actively and incoherently modifying one or more distances between one or more streamer front ends and a vessel towing the streamers.

Compressive sensing cannot reconstruct signal for regularly sub-sampled (beyond Nyquist) data. However, for irregularly sampled data, experience has shown that many good solutions exist that are close to the best solution. The solution space is fairly flat, i.e., many good solutions exist that are close to the theoretical optima. A practical approach is, therefore, to determine a near-optimal solution by iterating over a large number of dithering approaches, and then to choose among those the one that minimize a cost function. In other words, the steps 810-830 of claim 1 may be repeated to identify an optimum survey plan.

In an embodiment, the search for an optimal plan may be codified by the following pseudocode algorithm 1:

*for i=1:number of iterations*

    *Introduce irregularities in one dimension spacing with given constraints*

    *Compute a cost function value to assess these irregularities*

*end*

*Select the dimension spacing resulting in the minimum cost function*

The term "dimension spacing" used in the pseudocode means any single or combination of irregularity-inducing strategies listed in Table 1.

The optimal dimension spacing can then be used to create a pre-plot for the acquisition. Implicitly, various practical constraints such as, for example, the minimum and maximum allowed streamer separation can also be built into the cost function (e.g., using Langrage multipliers). Computationally, this approach is fast and efficient. In one dimension, the search space is normally limited, and a brute force approach is practical. The shot positions inaccuracies/uncertainties in source and receiver positioning of about 1 m taken into consideration render meaningless a dither step-length of less than 1 m.

In another embodiment, a near-optimal solution is sought by systematically running algorithm 1 with varying parameters for items (i.e., dimension) in Table 1. For example, an optimal static cross-line streamer separation may be determined first. Then, with this given streamer separation, an optimal dynamic irregular shot point interval (i.e., yielding inline irregularities) is determined. Then an optimal source steering may be determined (yielding dynamic cross-line irregularities) while maintaining the already-determined optimal static cross-line streamer separation and optimal source steering. One or more additional irregularity-inducing measures may be considered, before finally outputting a plan for the acquisition. The dimension spacings are both static (like streamer spacing which, at least near the front end of a spread, is set by a separation rope), and dynamic such as, for example, irregularities introduced by steering the source from side to side.

The above-described one-dimensional optimization may not lead to a global minimum and may also result in a non-optimal sampling with large un-sampled areas. In another embodiment these problems are alleviated, the search for an optimal plan being codified by the following pseudocode algorithm 2:

*for i=1:number of iterations*

    *Introduce dither in two or more dimensions*

    *Compute a cost function value to assess a current plan*

*end*

*Select the dithers associated with the minimum cost function*

In other words, a multi-dimensional search is performed to identify the optimal solution. The search may be shortened by using mathematical methods such as (but not limited to) "steepest ascent."

In another embodiment, the irregularities are generated by introducing so called low-discrepancy sequences. A low-discrepancy sequence is a sequence of numbers with the property that for all values of $N$, its subsequence $x_1$, ..., $x_N$ are close to uniformly distributed. Low-discrepancy sequences are also sometimes called quasi-random or sub-random sequences, due to their common use as a replacement of uniformly distributed random numbers. Examples of low-discrepancy sequences are Halton sequences and Hammersley sets. Numerical experiments have shown that low-discrepancy sequences result in restriction matrices or dictionary matrices with reasonably low mutual coherence or high entropy. They have, in addition, desirable feature such as an almost uniform distribution that ensures no large gaps between the sample acquisition points.

In yet another embodiment, the optimal dither for some dimensions is determined by using Algorithm 2, while the dither in other dimensions is set with the help of a low-discrepancy sequence. For example, with static dimensions like streamer spacing (set by the front-rope separation), the inline start position of each streamer of the receiver inline position is set using low-discrepancy sequences, and the dynamic dimensions, such as an irregular shot point interval or steering the receivers, source or vessels, are determined using Algorithm 2 (which may also use low-discrepancy sequences).

In another embodiment, dynamic 4D steering is used to achieve the desired irregularities in the acquisition. In this approach, vessel steering (amplitude and phase of turning) may be used to introduce long-period dithering, while streamer and source steering are used to introduce shorter-period dithering. The steering ability defines the maximum irregularities achievable for a survey. Steering can also be combined with dithering of the shot-point interval (inline) and using winches for the sources and the streamers. The restriction matrix or the dictionary matrix may be evaluated for several adjacent sail lines to ensure that no big holes are left in the acquisition.

The maximum size of gaps between acquisition points may be set as a function of geology. For a "flat" and uniform geology, larger holes might be acceptable compared to when the geology is rapidly changing in the subsurface.

In a survey system with multiple vessels, the source vessels normally have much more flexibility than the streamer vessels. The source vessels are therefore better suited to introduce both dynamic inline and cross-line irregularities in the seismic restriction or dictionary matrix. Furthermore, more static irregularities may be achieved by changing/dithering vessel separations both inline and cross-line.

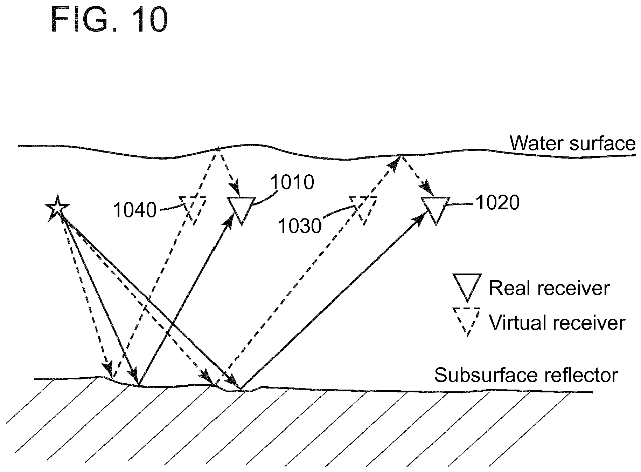

Deghosting also introduces irregularities in the sampling matrix. Figure 10 illustrates ghost estimates for two real receiver positions 1010 and 1020 that are back-propagated to create virtual receivers 1030 and 1040. The virtual receiver positions are non-stationary and depend on the acquisition geometry, geology (the direction of the reflected seismic signal) and time. Theoretically, virtual receivers may be created both in the cross-line and inline direction. However, for towed marine acquisition, the cross-line direction is probably more interesting. These virtual receivers being somewhat irregularly placed may be used together with the real receivers in a compressive sensing-based interpolation and regularization. This technique potentially also results in avoiding the use of multicomponent data in the interpolation step, since this kind if data is known to be noisy, especially for low frequencies. The irregularities due to these virtual receiver positions may also be combined with one or more other irregularities as listed in Table 1.

Besides the planned irregularities are combined with unplanned irregularities due to the environment. Currents, wind and swell frequently cause feathering both for both sources and receivers. These environment-caused irregularities are unpredictable and, therefore, cannot be evaluated in a planning stage before the survey. Streamer and source feathering may in practice make it impossible to steer a source or a streamer exactly as planned. This problem can be solved by running a near-real-time optimization, where a cost function continuously monitored and the data acquisition plan is updated to optimally counterbalance or take advantage of the environmental effects.

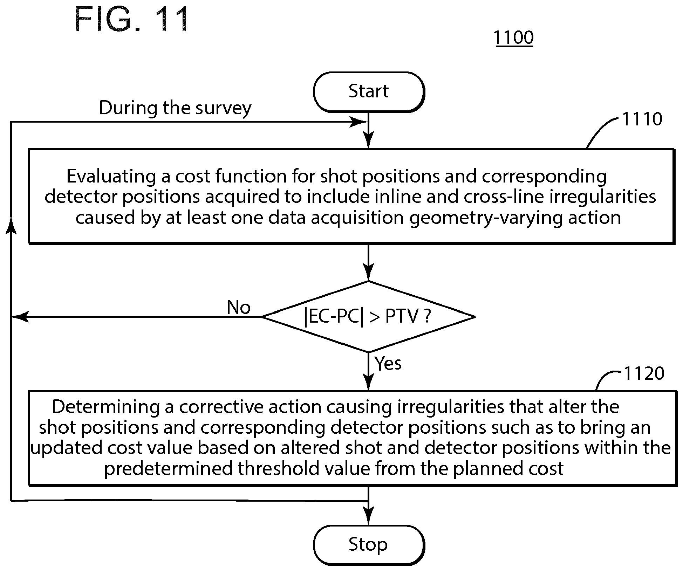

Figure 11 is a flowchart of a survey control method 1100 for monitoring and adjusting data acquisition geometry to achieve inline and cross-line seismic data irregularities optimized for compressive sensing reconstruction. Method 1100 includes evaluating a cost function for shot positions and corresponding detector positions acquired to include inline and cross-line irregularities caused by at least one data acquisition geometry-varying action at1110. Method 1100 further includes, at 1120, if the evaluated cost (EC) differs from a planned cost (PC) by more than a predetermined threshold value (PTV), determining a corrective action causing irregularities that alter the shot positions and corresponding detector positions so as to bring an updated cost value within the predetermined threshold value from the planned cost. Steps 1110 and 1120 are performed repeatedly at predetermined time intervals or at planned positions. Performing steps 1110 and 1120 may also be triggered by a request from an operator. Method 900 may also further include real-time monitoring and adjusting steps.

The planned survey is then adjusted to integrate the corrective action (e.g., steering the vessel(s), the source, and/or the streamer) determined at 1120 in the survey plan. Such adjustments are tuned to achieve a level of irregularities controlled by a quality control of a cost function. The survey control method ensures the inline and cross-line irregularities while reducing the constraints on the positions themselves. It allows preserving the properties of the irregularities even in challenging environmental conditions. There are also benefits in terms of mechanical fatigue and maintenance needs to control the pattern of use of the steering systems. The steering systems may not need to counter the environmental effects, but can (partly) act independently of them.

For data acquisition systems where the receivers are not towed or not deployed on the sea floor, but released inside the water column, such as AUVs, and move with currents, the natural irregularities of the distribution of AUVs is complemented by the steering of towed sources (vessels steering, source steering and dithered shooting patterns) in order to optimize the required irregularities for compressive sensing. Initial cost function evaluation based on current prediction may be constantly updated during the acquisition in order to maintain the predefined compressive sensing requirements (e.g., a mutual coherence threshold). The same method is applied if sources are deployed through a flotilla of AUVs.

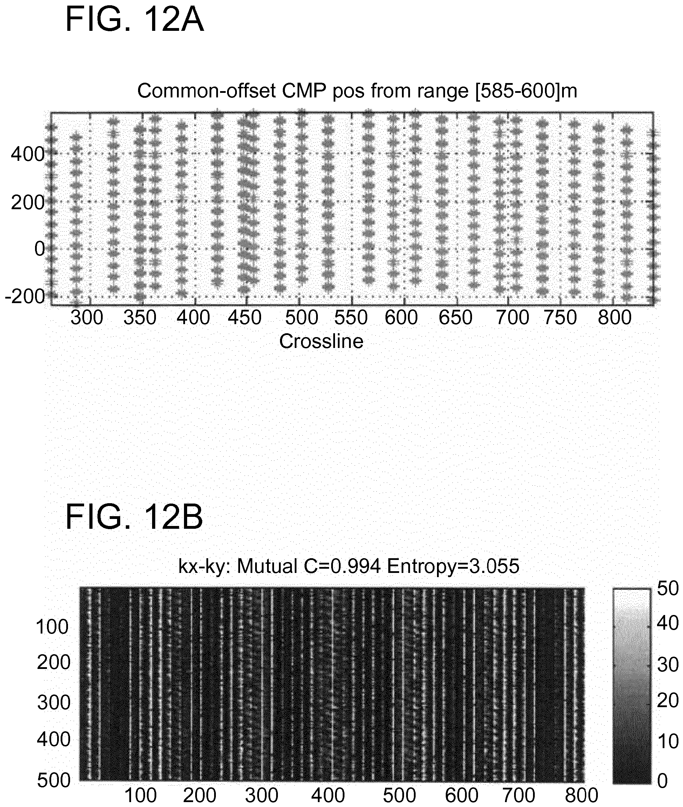

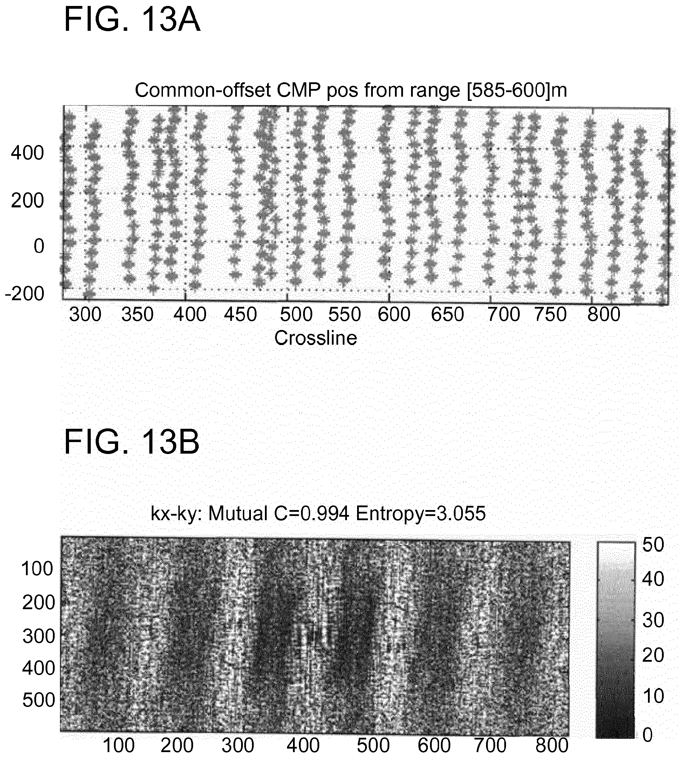

Figures 12A, 12B, 13A and 13B illustrate the effect of acquiring data according to the above-described methods output. Figures 12A and 13A illustrate CMP positions generated from a simulation of towed marine acquisition for one sail-line with two sources and 12 streamers. Figures 12B and 13B are the kx-ky plot of the corresponding restriction matrices.

Figures 12A and 12B correspond to data acquisition with irregular streamer cross-line intervals. Figure 12B reveals lots of coherent structures and a mutual coherence that is close to 1.0, which indicates a bad scenario for compressive sensing recovery.

Figures 13A and 13B correspond to data acquisition with source steering besides irregular streamer cross-line intervals and both feathering (when ocean currents push streamers sideways relative to the towing direction) and streamer fanning (when the streamers are actively steered to have a larger separation at a distal end than the end near the towing vessel). Figure 13B reveals significant irregularities in the restriction matrix, and far less coherency. This is reflected by improved values for both the mutual coherence and entropy.

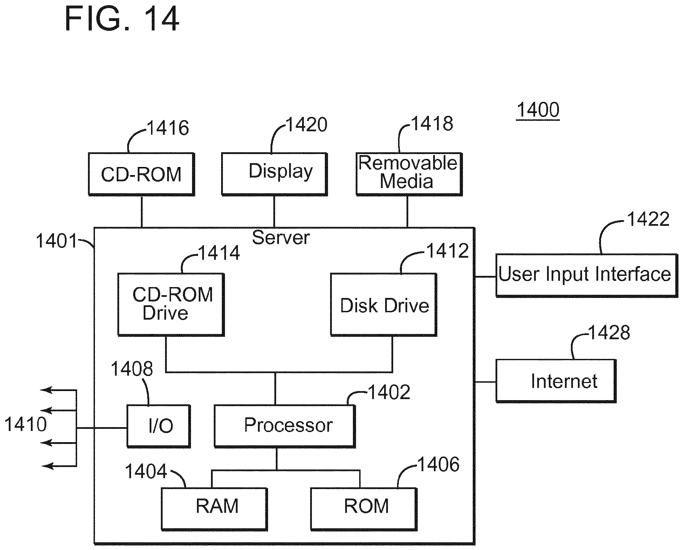

The above-discussed methods may be implemented in a computing device 1400 as illustrated in Figure 14. Hardware, firmware, software or a combination thereof may be used to perform the various steps and operations described herein.

Exemplary computing device 1400 suitable for performing the activities described in the exemplary embodiments may include a server 1401. Server 1401 may include a central processor (CPU) 1402 coupled to a random access memory (RAM) 1404 and to a read-only memory (ROM) 1406. ROM 1406 may also be other types of storage media to store programs, such as programmable ROM (PROM), erasable PROM (EPROM), etc. Processor 1402 may communicate with other internal and external components through input/output (I/O) circuitry 1408 and bussing 1410 to provide control signals and the like. Processor 1402 carries out a variety of functions as are known in the art, as dictated by software and/or firmware instructions.

Server 1401 may also include one or more data storage devices, including hard drives 1412, CD-ROM drives 1414 and other hardware capable of reading and/or storing information, such as DVD, etc. In one embodiment, software for carrying out the above-discussed steps may be stored and distributed on a CD-ROM or DVD 1416, a USB storage device 1418 or other form of media capable of portably storing information. These storage media may be inserted into, and read by, devices such as CD-ROM drive 1414, disk drive 1412, etc. Server 1401 may be coupled to a display 1420, which may be any type of known display or presentation screen, such as LCD, plasma display, cathode ray tube (CRT), etc. A user input interface 1422 is provided, including one or more user interface mechanisms such as a mouse, keyboard, microphone, touchpad, touch screen, voice-recognition system, etc.

Server 1401 may be coupled to other devices, such as sources, detectors, etc. The server may be part of a larger network configuration as in a global area network (GAN) such as the Internet 1428, which allows ultimate connection to various computing devices.

The disclosed exemplary embodiments provide methods for designing or adjusting a survey plan that achieves inline and cross-line seismic data irregularities suitable for compressive sensing reconstruction. It should be understood that this description is not intended to limit the invention. On the contrary, the exemplary embodiments are intended to cover alternatives, modifications and equivalents, which are included in the spirit and scope of the invention as defined by the appended claims. Further, in the detailed description of the exemplary embodiments, numerous specific details are set forth in order to provide a comprehensive understanding of the claimed invention. However, one skilled in the art would understand that various embodiments may be practiced without such specific details.

Although the features and elements of the present exemplary embodiments are described in the embodiments in particular combinations, each feature or element can be used alone without the other features and elements of the embodiments or in various combinations with or without other features and elements disclosed herein.

This written description uses examples of the subject matter disclosed to enable any person skilled in the art to practice the same, including making and using any devices or systems and performing any incorporated methods. The patentable scope of the subject matter is defined by the claims, and may include other examples that occur to those skilled in the art. Such other examples are intended to be within the scope of the claims.

**Claims**

1. A method (900) for designing a survey plan that achieves inline and cross-line seismic data irregularities suitable for compressive sensing reconstruction, the method comprising:

    determining (910) shot positions and corresponding detector positions of a survey plan with inline and cross-line irregularities caused by at least one data acquisition geometry-varying action;

evaluating (920) a cost function value for the determined shot and detector positions; and

determining (930), using the cost function value, whether seismic data acquired according to the survey plan is suitable compressive sensing reconstruction.

2. The method of claim 1, wherein the at least one data acquisition geometry-varying action includes actively steering cross-line a source using source steering means, the source generating at least some of shots.

3. The method of claim 1, wherein the at least one data acquisition geometry-varying action includes actively steering cross-line one or more streamers using streamer steering means, the one or more streamers carrying detectors.

4. The method of claim 1, wherein the at least one data acquisition geometry-varying action includes actively steering cross-line a source vessel, which tows a source generating at least some shots, and/or a streamer vessel, which tows one or more streamers.

5. The method of claim 1, wherein the at least one data acquisition geometry-varying action includes shooting a source at irregular intervals.

6. The method of claim 1, wherein the at least one data acquisition geometry-varying action includes actively and incoherently modifying a distance between a source and a vessel towing the source.

7. The method of claim 1, wherein the at least one data acquisition geometry-varying action includes actively and incoherently modifying one or more distances between one or more streamer front ends and a vessel towing the streamers.

8. The method of claim 1, wherein in addition to the at least one data acquisition geometry-varying action, the inline and/or cross-line irregularities are caused by one or more static data acquisition geometry features including at least one of irregular receiver spacing, irregular streamer spacing, streamer feathering and/or fanning, towing streamers to have front ends thereof at different inline positions, and irregular source strings spacing.

9. The method of claim 1, wherein
   the at least one data acquisition geometry-varying action pertains to a group of actions and data acquisition geometry features usable to achieve to achieve simultaneously the inline and cross-line irregularities, and
   the determining of the shot positions and corresponding detector positions, the evaluating of the cost function value, and the determining of whether the seismic data acquired according to the survey plan is suitable for compressive sensing reconstruction are performed successively for the at least one data acquisition geometry-varying action and another action or data acquisition geometry feature in the group.

10. The method of claim 9, further comprising
    simultaneously introducing dithers associated with the at least one data acquisition geometry-varying action and another action or data acquisition geometry feature in the group before the determining of the shot positions and corresponding detector positions, the evaluating of the cost function value, and the determining of whether the seismic data acquired according to the survey plan is suitable for compressive sensing reconstruction.

11. The method of claim 1, further comprising
    introducing dither associated with the at least one data acquisition geometry-varying action before the determining of the shot positions and corresponding detector positions, the evaluating of the cost function value, and the determining of whether the seismic data acquired according to the survey plan is suitable for compressive sensing reconstruction,
    wherein the dither uses a low-discrepancy sequence.

12. The method of claim 1, further comprising:

    introducing depth related irregularities.

13. The method of claim 1, further comprising:

    monitoring actual shot positions and corresponding detector positions during a survey according to the survey plan;

evaluating a real-time cost function value for the actual shot and detector positions; and

if a difference between the real-time cost function value and the cost function value according to the survey plan exceeds a predetermined threshold, determining at least one corrective action causing irregularities that alter the actual shot positions and corresponding detector positions such as to bring an updated cost value within the predetermined threshold value from the cost function value according to the survey plan.

14. A survey control method (1100) for monitoring and adjusting data acquisition geometry to achieve inline and cross-line seismic data irregularities suitable for compressive sensing reconstruction, the method repeatedly performing:

evaluating (1110) a cost function for shot positions and corresponding detector positions acquired to include inline and cross-line irregularities caused by at least one data acquisition geometry-varying action; and

if an evaluated cost differs from a planned cost by more than a predetermined threshold value, determining (1120) a corrective action causing irregularities that alter the shot positions and corresponding detector positions such as to bring an updated cost value based on altered shot and detector positions within the predetermined threshold value from the planned cost,

wherein the at least one data acquisition geometry-varying action and the corrective action includes one or more of

actively steering cross-line a source using source steering means, the source generating at least some shots,

actively steering cross-line one or more streamers using streamer steering, the one or more streamers carrying detectors,

actively steering cross-line a source vessel and/or a streamer vessel, towing the source and the one or more streamers, respectively,

shooting the source at irregular intervals,

actively and incoherently modifying a distance between the source and the source vessel, and

actively and incoherently modifying one or more distances between the one or more streamers the streamer vessel.

15. A data acquisition control apparatus (1400) configured to design and/or adjust source, vessel and/or streamer trajectories during a survey to achieve inline and cross-line seismic data irregularities optimized for compressive sensing reconstruction, the apparatus comprising:

an interface (1410) configured to receive data acquisition related information and to output a survey plan and/or a correction thereof; and

a data processing unit (1402) connected to the interface and configured

to evaluate a cost function value for a set of shot and detector positions with inline in cross-line irregularities caused by at least one data acquisition geometry-varying action; and

to determine, using the cost function value, whether seismic data acquired according to the set of shot and detector positions is suitable compressive sensing reconstruction.

FIG. 1

EP 3 206 052 A1

FIG. 2

# FIG. 3A

Linearly coherent samples

y-pos

x-pos

# FIG. 3B

kx-ky plot

Mutual coherence: 0.994465

# FIG. 4A

Snacky coherent samples

y-pos

x-pos

# FIG. 4B

kx-ky plot

Mutual coherence: 0.994465

# FIG. 5A

Snacky coherent samples

y-pos

x-pos

# FIG. 5B

kx-ky plot

Mutual coherence: 0.994465

FIG. 6A

Interpolation and Acquisition grids

FIG. 6B

$A^{H}A$          x 10$^{-3}$

FIG. 6C

Average amplitude of diagonls of $A^{T}A$

Average of diagonals

Diagonal number

FIG. 6D

Amplitude of artefacts z = Lx$_{0}$

Amplitude

Rows

# FIG. 7A

**Interpolation and Acquisition grids**

# FIG. 7B

$A^HA$    x 10$^{-3}$

**Average amplitude of diagonls of $A^TA$**

Average of diagonals

Diagonal number

## FIG. 7C

**Amplitude of artefacts $z = Lx_0$**

Amplitude

Rows

## FIG. 7D

# FIG. 8A

Interpolation and Acquisition grids

# FIG. 8B

$A^H A$   x 10$^{-3}$

Average amplitude of diagonls of $A^T A$

Average of diagonals

Diagonal number

# FIG. 8C

Amplitude of artefacts $z = Lx_0$

Amplitude

Rows

# FIG. 8D

# FIG. 9

<u>900</u>

Start

┌─910

Determining shot positions and corresponding detector positions of a survey plan with inline and cross-line irregularities caused by at least one data acquisition geometry-varying action

┌─920

Evaluating a cost function value for the determined shot and detector positions

┌─930

Determining, using the cost function value, whether seismic data acquired according to the survey plan is suitable compressive sensing reconstruction

Stop

# FIG. 10

Water surface

1010

1040

1030

1020

▽ Real receiver

Virtual receiver

Subsurface reflector

# FIG. 11

1100

During the survey

Start

1110

Evaluating a cost function for shot positions and corresponding detector positions acquired to include inline and cross-line irregularities caused by at least one data acquisition geometry-varying action

No ← |EC-PC| > PTV ?

Yes

1120

Determining a corrective action causing irregularities that alter the shot positions and corresponding detector positions such as to bring an updated cost value based on altered shot and detector positions within the predetermined threshold value from the planned cost

Stop

## FIG. 12A

Common-offset CMP pos from range [585-600]m

## FIG. 12B

kx-ky: Mutual C=0.994 Entropy=3.055

# FIG. 13A

Common-offset CMP pos from range [585-600]m

Crossline

# FIG. 13B

kx-ky: Mutual C=0.994 Entropy=3.055

# FIG. 14

Europäisches
Patentamt

European
Patent Office

Office européen
des brevets

# EUROPEAN SEARCH REPORT

Application Number

EP 17 30 5155

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | REZA SHAHIDI ET AL: "Application of randomized sampling schemes to curvelet-based sparsity-promoting seismic data recovery : Application of randomized sampling schemes to seismic data recovery", GEOPHYSICAL PROSPECTING, vol. 61, no. 5, 1 September 2013 (2013-09-01), pages 973-997, XP055379505, ISSN: 0016-8025, DOI: 10.1111/1365-2478.12050 | 1-4,6,7, 15 | INV. G01V1/38 G01V1/00 |
| Y A | * Sections: CRSI and 2D irregular subsampling schemes; Curvelet-based reconstruction by sparsity-promoting inversion; Results and discussion * * figure 4 * ----- | 5,8-12 13,14 | |
| Y | HASSAN MANSOUR ET AL: "Randomized marine acquisition with compressive sampling matrices : Compressive sampling marine acquisition", GEOPHYSICAL PROSPECTING, vol. 60, no. 4, 23 May 2012 (2012-05-23), pages 648-662, XP055378705, ISSN: 0016-8025, DOI: 10.1111/j.1365-2478.2012.01075.x | 5 | |
| A | * Section: Designing the randomized operator * ----- | 13,14 | |
| Y | WO 2016/009270 A1 (CGG SERVICES SA [FR]) 21 January 2016 (2016-01-21) | 8-10,12 | |
| A | * paragraphs [0071], [0073], [0078], [0081], [0116] * ----- | 13,14 | |

TECHNICAL FIELDS
SEARCHED (IPC)

G01V
H03M

-/--

The present search report has been drawn up for all claims

| Place of search | Date of completion of the search | Examiner |
|---|---|---|
| The Hague | 9 June 2017 | Mirkovic, Olinka |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

page 1 of 2

Europäisches
Patentamt
European
Patent Office
Office européen
des brevets

## EUROPEAN SEARCH REPORT

Application Number

EP 17 30 5155

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | TIEN-TSIN WONG ET AL: "Sampling with Hammersley and Halton Points", JOURNAL OF GRAPHICS TOOLS, ASSOCIATION FOR COMPUTING MACHINERY, NEW YORK, US, vol. 2, no. 2, 1 January 1997 (1997-01-01), pages 9-24, XP002452402, ISSN: 1086-7651 | 11 | |
| A | * the whole document * | 13,14 | |
| A | MAFIJUL BHUIYAN ET AL: "Optimization for sparse acquisition", SEG TECHNICAL PROGRAM EXPANDED ABSTRACTS 2015, 19 August 2015 (2015-08-19), pages 254-259, XP055378760, DOI: 10.1190/segam2015-5931123.1 * the whole document * | 1-15 | |
| A | US 2015/124560 A1 (BREWER J D; KAPLAN S T; KEYS R G; LI C; MOSHER C C) 7 May 2015 (2015-05-07) * the whole document * | 1-15 | TECHNICAL FIELDS SEARCHED (IPC) |

The present search report has been drawn up for all claims

| Place of search | Date of completion of the search | Examiner |
|---|---|---|
| The Hague | 9 June 2017 | Mirkovic, Olinka |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 17 30 5155

This annex lists the patent family members relating to the patent documents cited in the above-mentioned European search report.
The members are as contained in the European Patent Office EDP file on
The European Patent Office is in no way liable for these particulars which are merely given for the purpose of information.

09-06-2017

| Patent document cited in search report | | Publication date | Patent family member(s) | | Publication date |
|---|---|---|---|---|---|
| WO 2016009270 | A1 | 21-01-2016 | AU | 2015291300 A1 | 02-02-2017 |
| | | | EP | 3170028 A1 | 24-05-2017 |
| | | | US | 2017160415 A1 | 08-06-2017 |
| | | | WO | 2016009270 A1 | 21-01-2016 |
| US 2015124560 | A1 | 07-05-2015 | AU | 2014342041 A1 | 09-06-2016 |
| | | | CA | 2947678 A1 | 07-05-2015 |
| | | | US | 2015124560 A1 | 07-05-2015 |
| | | | WO | 2015066481 A1 | 07-05-2015 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 62294344 A
- US 62306178 A
- US 8593904 B
- US 8462581 B
- US 8891331 B
- US 8889332 B
- US 8897094 B
- US 9188693 B
- US 8780669 B
- US 8681581 B
- US 8711654 B
- US 20110317517 A
- US 62299567 A

### Non-patent literature cited in the description

- **LI et al.** Marine towed streamer data reconstruction based on compressive sensing. *SEG Technical Program Expanded Abstracts,* 2013, 3597-3602
- **MOSHER et al.** Increasing the efficiency of seismic data acquisition via compressive sensing. *The leading edge,* vol. 33 (4), 386-391
- **CANDÈS et al.** *Communications on Pure and Applied Mathematics,* vol. 59 (8), 1207-1223
- **HENNENFENT et al.** Simply denoise: wavefield reconstruction via jittered undersampling. *Geophysics,* 2008, vol. 73 (3), V19-V28